# DEMANDE DE BREVET EUROPEEN

(11) **EP 4 386 826 A1**
(43) Date de publication de la demande: **19.06.2024**
(21) Numéro de dépôt: 23215732.1
(22) Date de dépôt: 12.12.2023
(51) Int. Cl.: H01L 21/8234, H01L 21/324, H01L 21/8238, H01L 21/02, H01L 29/78, H01L 29/10, H01L 21/268

(54) **PROCÉDÉ DE FABRICATION D'UN DISPOSITIF SEMI-CONDUCTEUR**

(30) Priorité: 13.12.2022 FR 2213229
(71) Demandeur: Commissariat à l'énergie atomique et aux énergies alternatives, 75015 Paris (FR)
(72) Inventeur: ACOSTA ALBA, Pablo, 38054 Grenoble Cedex 09 (FR); REBOH, Shay, 38054 Grenoble Cedex 09 (FR)
(74) Mandataire: Cabinet Camus Lebkiri

(57) **Abrégé**

Un aspect de l'invention concerne un procédé de fabrication d'un dispositif semiconducteur comprenant une première zone semi-conductrice optimisée pour la conduction par électrons et une deuxième zone semi-conductrice optimisée pour la conduction par trous, le procédé comprenant les étapes suivantes :
- fournir une structure multicouches comprenant un substrat et une couche de silicium-germanium disposée sur le substrat ;
- définir dans la structure multicouches une première région destinée à contenir la première zone semi-conductrice et une deuxième région destinée à contenir la deuxième zone semi-conductrice ;
- soumettre la structure multicouches à un recuit laser de manière à modifier une portion de la structure multicouches située dans la première région, ladite portion comprenant avant le recuit laser une partie de la couche de silicium-germanium, ladite portion comprenant après le recuit laser une partie appauvrie en germanium et une partie enrichie en germanium disposée sur la partie appauvrie en germanium ;
- graver la partie enrichie en germanium de manière à exposer la partie appauvrie en germanium.

## Description

### DOMAINE TECHNIQUE

La présente invention concerne un procédé de fabrication d'un dispositif semi-conducteur comprenant une première zone semi-conductrice optimisée pour la conduction par électrons et une deuxième zone semi-conductrice optimisée pour la conduction par trous.

L'invention peut faciliter la cointégration, sur un même substrat semi-conducteur, d'un transistor à effet de champ à canal N et d'un transistor à effet de champ à canal P.

### ÉTAT DE LA TECHNIQUE

Un transistor à effet de champ (ou FET, pour « field effect transistor » en anglais) à canal N, communément appelé transistor nFET, est un transistor dont la conduction est assurée par des électrons. A l'inverse, un transistor à effet de champ à canal P, communément appelé transistor pFET, est un transistor dont la conduction est assurée par des trous.

Dans le but d'améliorer les performances des transistors à effet de champ, notamment en termes de rapidité, il est connu de former le canal de conduction des transistors nFET dans une première zone semi-conductrice en un matériau favorisant la conduction par électrons et le canal de conduction des transistors pFET dans une deuxième zone semi-conductrice en un matériau favorisant la conduction par trous.

Plus particulièrement, une architecture avancée en technologie CMOS (« complementary metal-oxide-semiconductor » en anglais) consiste à utiliser des canaux en silicium (Si) pour les transistors à effet de champ de type NMOS et des canaux en silicium-germanium (SiGe) pour les transistors à effet de champ de type PMOS. L'utilisation de canaux en SiGe pour les transistors PMOS est connue pour améliorer la mobilité des porteurs de charge (trous) et diminuer la tension de seuil des transistors par rapport au silicium seul. Une forte concentration en germanium (typiquement supérieure à 20 %) est généralement recherchée, étant donné que la mobilité des porteurs de charge augmente avec la concentration en germanium. Pour améliorer encore la mobilité des porteurs de charge, les canaux en Si peuvent être contraints en tension et les canaux en SiGe peuvent être contraints en compression.

La coexistence d'un transistor PMOS à canal SiGe et d'un transistor NMOS à canal Si sur un même substrat peut être rendue possible en transformant une portion d'une couche de silicium (typiquement la couche mince d'un substrat SOI) en une portion de silicium-germanium, au moyen d'une technique appelée condensation localisée de germanium. Cette technique comprend une étape de croissance par épitaxie d'une couche de SiGe sur la portion de couche de silicium à transformer et une étape d'oxydation de la couche de SiGe. Cette étape d'oxydation, dite « sélective » par rapport au silicium, a pour effet de repousser les atomes de germanium dans la couche de silicium sous-jacente tout en formant une couche d'oxyde de silicium (SiO₂) en surface. Après retrait de la couche d'oxyde de silicium, le canal du transistor PMOS est formé dans la portion transformée en SiGe tandis que le canal du transistor NMOS est formée dans une portion non modifiée de la couche de silicium.

La condensation de germanium est dite localisée, car elle se produit uniquement dans les régions où l'on souhaite former des transistors PMOS. L'empilement de couches initial est différent entre les régions accueillant les transistors NMOS (couche de Si seulement) et les régions accueillant les transistors PMOS (couche de Si + couche de SiGe). Or la croissance de SiGe sur certaines régions seulement de la couche de silicium peut s'avérer délicate.

Par ailleurs, le document [« Investigation of recrystallization and stress relaxation in nanosecond laser annealed Si₁₋ₓGeₓ/Si epilayers » ; L. Dagault et al. ; Applied Surface Science, Volume 527, 2020] décrit une couche de SiGe formée par épitaxie sur un substrat en silicium, puis soumise à un recuit laser nanoseconde (ou NLA, pour « nanosecond laser annealing » en anglais). Le recuit laser nanoseconde entraîne une fusion au moins partielle de la couche de SiGe. Une redistribution des atomes de germanium est observée lors de la recristallisation de la couche de SiGe. Les atomes de germanium sont concentrés vers la surface de la couche de SiGe, du fait d'un mécanisme de ségrégation. Il en résulte un gradient de concentration en germanium dans l'épaisseur de la couche de SiGe. Cette technique peut être utilisée pour diminuer la résistivité électrique des contacts de source et de drain dans les transistors PMOS (régions de source et de drain en SiGe).

### RESUMÉ DE L'INVENTION

L'invention a pour but de simplifier la fabrication d'un dispositif semi-conducteur comprenant une première zone semi-conductrice optimisée pour la conduction par électrons et une deuxième zone semi-conductrice optimisée pour la conduction par trous.

Selon l'invention, on tend à atteindre ce but en prévoyant un procédé de fabrication comprenant les étapes suivantes :
- fournir une structure multicouches comprenant :
   - un substrat ; et
   - une couche de silicium-germanium disposée sur le substrat ;
- définir dans la structure multicouches une première région destinée à contenir la première zone semi-conductrice et une deuxième région destinée à contenir la deuxième zone semi-conductrice ;
- soumettre la structure multicouches à un recuit laser de manière à modifier une portion de la structure multicouches située dans la première région, ladite portion comprenant avant le recuit laser une partie de la couche de silicium-germanium, ladite portion comprenant après le recuit laser une partie appauvrie en germanium et une partie enrichie en germanium disposée sur la partie appauvrie en germanium ;
- graver la partie enrichie en germanium de manière à exposer la partie appauvrie en germanium.

Ce procédé de fabrication permet d'obtenir, en partant d'un même empilement de départ, une première zone semi-conductrice optimisée pour la conduction par électrons et une deuxième zone semi-conductrice optimisée pour la conduction par trous. La première zone semi-conductrice optimisée pour la conduction par électrons est obtenue en concentrant les atomes de germanium de la couche de silicium-germanium dans une région de la structure multicouches, puis en gravant la partie enrichie en germanium pour exposer la partie appauvrie en germanium. Le recuit laser est en outre simple et rapide à mettre en oeuvre.

De préférence, la couche de silicium-germanium présente avant le recuit laser une concentration en germanium supérieure ou égale à 30 %.

Avantageusement, la structure multicouches comprend en outre une couche de protection disposée sur la couche de silicium-germanium et ladite portion s'étend avant le recuit laser jusqu'à la couche de protection, le procédé comprenant en outre une étape de retrait de la couche de protection dans la première région de la structure multicouches avant l'étape de gravure de la partie enrichie en germanium.

De préférence, la structure multicouches comprend en outre une couche de réflexion laser disposée sur la couche de protection, le procédé comprenant en outre, avant le recuit laser, une étape de gravure d'une portion de la couche de réflexion laser située dans la première région de la structure multicouches.

Le procédé peut comprendre en outre, après l'étape de gravure de la partie enrichie en germanium, les étapes suivantes :
- structurer la partie appauvrie en germanium de manière à former une pluralité de premières ailettes dans la première région de la structure multicouches ;
- retirer la couche de réflexion laser et la couche de protection située dans la deuxième région de la structure multicouches ;
- structurer la couche de silicium-germanium de manière à former une pluralité de deuxièmes ailettes dans la deuxième région de la structure multicouches.

L'étape de définition des première et deuxième régions de la structure multicouches est accomplie après l'étape de fourniture de la structure multicouches et comprend les sous-étapes suivantes :
- graver une tranchée dans la structure multicouche, la tranchée s'étendant à travers la couche de réflexion laser, la couche de protection et la couche de silicium-germanium jusqu'au substrat ; et
- remplir la tranchée d'un matériau électriquement isolant sur au moins toute l'épaisseur de la couche de silicium-germanium.

Dans un mode de réalisation :
- la couche de silicium-germanium comprend une pluralité d'ailettes réparties entre les première et deuxième régions de la structure multicouches ;
- la structure multicouches comprend en outre des tranchées d'isolation électrique séparant les ailettes entre elles ; et
- la structure multicouches est soumise au recuit laser de manière à modifier plusieurs portions de la structure multicouches situées dans la première région et plusieurs portions de la structure multicouches situées dans la deuxième région, chaque portion comprenant avant le recuit laser une partie au moins d'une ailette.

Selon un développement de ce mode de réalisation, l'étape de fourniture de la structure multicouches comprend les opérations suivantes :
a) déposer la couche de silicium-germanium sur le substrat ;
b) graver la couche de silicium-germanium de manière à former la pluralité d'ailettes ;
c) former les tranchées d'isolation électrique entre les ailettes ; et
d) déposer la couche de protection sur la couche de silicium-germanium.

La couche de protection et les tranchées d'isolation électrique sont de préférence formées d'un même matériau électriquement isolant.

Le procédé de fabrication selon l'invention peut également présenter une ou plusieurs des caractéristiques ci-dessous, considérées individuellement ou selon toutes les combinaisons techniquement possibles :
- le recuit laser est accompli en exposant la structure multicouches à un rayonnement laser présentant une longueur d'onde comprise entre 200 nm et 600 nm et une densité d'énergie comprise entre 0,1 J/cm² et 10 J/cm² pendant une durée comprise entre 10 ns et 1000 ns ;
- le procédé comprend en outre une étape de formation d'un transistor à effet de champ à canal N, dit transistor nFET, dans la première région de la structure multicouches et une étape de formation d'un transistor à effet de champ à canal P, dit transistor pFET, dans la deuxième région de la structure multicouches.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes.
- les figures 1A à 1D représentent un premier mode de mise en oeuvre du procédé de fabrication selon l'invention ;
- les figures 2A à 2D représentent un deuxième mode de mise en oeuvre du procédé de fabrication selon l'invention ;
- les figures 3A à 3D représentent un troisième mode de mise en oeuvre du procédé de fabrication selon l'invention ;
- les figures 4A à 4E représentent un quatrième mode de mise en oeuvre du procédé de fabrication selon l'invention ;
- les figures 5A à 5D représentent un cinquième mode de mise en oeuvre du procédé de fabrication selon l'invention ;
- les figures 6A à 6D représentent un sixième mode de mise en oeuvre du procédé de fabrication selon l'invention ;
- les figures 7A à 7C représentent un septième mode de mise en oeuvre du procédé de fabrication selon l'invention ; et
- la figure 8 représente des étapes additionnelles du procédé de fabrication selon l'invention.

Pour plus de clarté, les éléments identiques ou similaires sont repérés par des signes de référence identiques sur l'ensemble des figures.

### DESCRIPTION DÉTAILLÉE

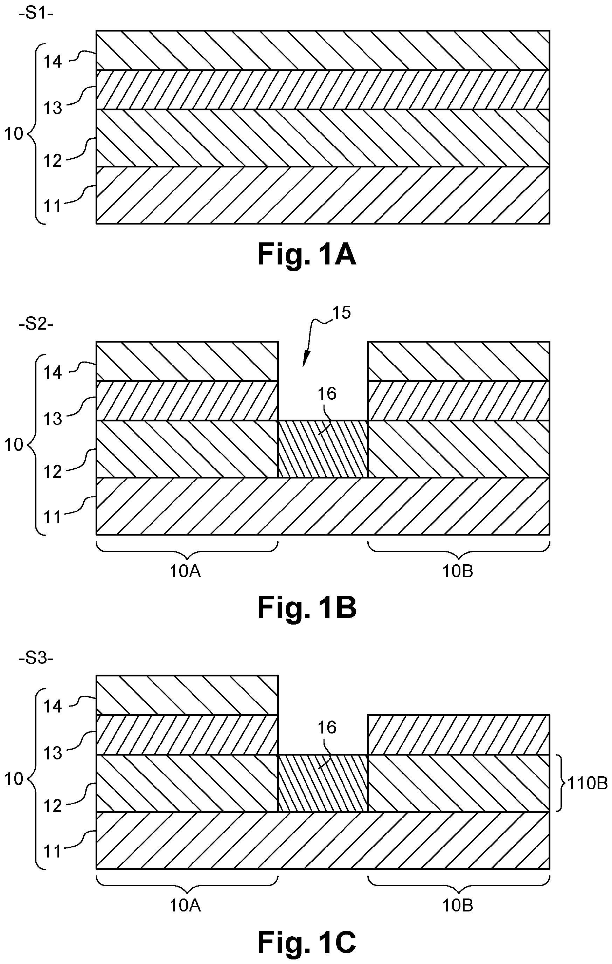

Les figures 1A-1D, 2A-2D, 3A-3D et 4A-4E représentent quatre modes de mise en oeuvre d'un procédé de fabrication de dispositif semi-conducteur comprenant une première zone semi-conductrice 100A optimisée pour la conduction par électrons et une deuxième zone semi-conductrice 100B optimisée pour la conduction par trous.

Les électrons présentent une mobilité plus élevée dans la première zone semi-conductrice 100A que dans la deuxième zone semi-conductrice 100B, tandis que les trous présentent une mobilité plus élevée dans la deuxième zone semi-conductrice 100B que dans la première zone semi-conductrice 100A.

La première zone semi-conductrice 100A est constituée d'un matériau (semi-conducteur) favorisant la conduction par électrons. De préférence, le matériau de la première zone semi-conductrice 100A est à base de silicium et présente une concentration en silicium supérieure à 90 %. La première zone semi-conductrice 100A peut notamment être en silicium ou en un alliage de silicium-germanium présentant une concentration en germanium inférieure ou égale à 10 %. Les concentrations données dans cette description sont des concentrations atomiques (aussi appelées pourcentages atomiques).

La deuxième zone semi-conductrice 100B est constituée d'un matériau (semi-conducteur) favorisant la conduction par trous. De préférence, le matériau de la deuxième zone semi-conductrice 100B comprend du germanium et présente une concentration en germanium supérieure ou égale à 20 %. La deuxième zone semi-conductrice 100B est par exemple en un alliage de silicium-germanium (présentant une concentration en germanium supérieure ou égale à 20 %).

Avantageusement, la première zone semi-conductrice 100A est destinée à former le canal de conduction d'un ou plusieurs transistors à effet de champ à canal N (nFET), tandis que la deuxième zone semi-conductrice 100B est destinée à former le canal de conduction d'un ou plusieurs transistors à effet de champ à canal P (pFET). Ainsi, les première et deuxième zones semi-conductrices 100A-100B pourront être également appelées zones (ou couches) de canal, ou encore zones (ou couches) actives.

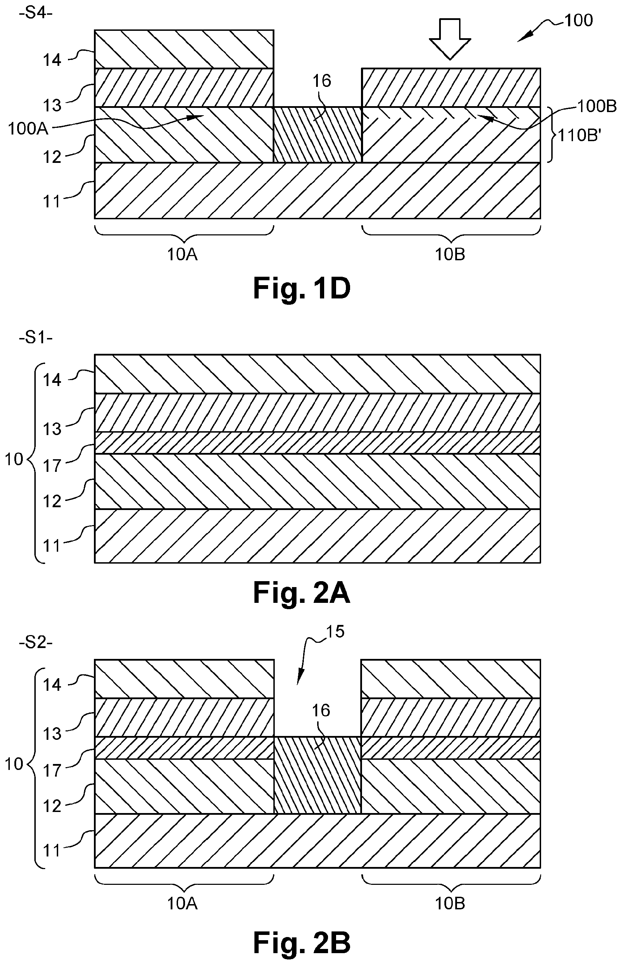

D'une manière commune aux quatre modes de mise en oeuvre, le procédé de fabrication comprend les étapes S1, S2 et S4 suivantes :
- S1 : fournir une structure multicouches 10 (ou empilement) comprenant un substrat 11 et une couche de silicium-germanium (SiGe) 12 disposée sur le substrat 11 (cf. Figs.1A, 2A, 3A-3B et 4A-4B) ;
- S2 : définir dans la structure multicouches 10 une première région 10A destinée à contenir la première zone semi-conductrice 100A et une deuxième région 10B destinée à contenir la deuxième zone semi-conductrice 100B (cf. Figs.1B, 2B, 3A-3B et 4A-4B) ; et
- S4 : soumettre la structure multicouches 10 à un recuit laser, de préférence de type nanoseconde, de manière à modifier une ou plusieurs portions 110B de la structure multicouches 10 situées dans la deuxième région 10B, chaque portion 110B comprenant avant le recuit laser une partie de la couche de SiGe 12, chaque portion étant modifiée de sorte qu'elle présente après le recuit laser un gradient de concentration en germanium avec une concentration en germanium qui augmente en direction d'une face supérieure de ladite portion (cf. Figs.1D, 2D, 3D et 4D).

Dans les figures annexées, ces étapes S1, S2 et S4 sont représentées de manière schématique par des vues en coupe.

On rappelle que le terme « sur » utilisé ci-dessus pour préciser l'agencement des couches signifie « au-dessus », et pas « en contact ». Ainsi, la structure multicouches 10 peut comporter, entre deux couches disposées l'une sur l'autre, une ou plusieurs autres couches (de sorte que les deux couches ne sont pas en contact).

Avantageusement, la structure multicouches 10 comprend en outre une couche de protection 13 disposée sur la couche de SiGe 12. Chaque portion 110B modifiée par le recuit laser s'étend alors jusqu'à la couche de protection 13 et présente une concentration en germanium qui augmente en direction de l'interface avec la couche de protection 13.

L'étape S1 de fourniture de la structure multicouches 10 peut notamment comprendre une sous-étape de dépôt de la couche de SiGe 12 sur le substrat 11 et une sous-étape de dépôt de la couche de protection 13 sur la couche de SiGe 12. De préférence, la couche de SiGe 12 et la couche de protection 13 sont déposées de manière à recouvrir toute une face du substrat 11 (dépôt dit « pleine plaque »).

Le substrat 11 peut notamment être un substrat massif (« bulk » en anglais) en un matériau semiconducteur, par exemple en silicium, ou un substrat de type silicium sur isolant (ou SOI, pour « silicon on insulator » en anglais).

La couche de SiGe 12 est de préférence formée par épitaxie (on parle alors de croissance).

La couche de protection 13 est de préférence constituée d'un oxyde de silicium, par exemple le dioxyde de silicium (ex. SiO₂). Elle peut être formée par toute technique de dépôt, par exemple PECVD, ALD, PEALD, ou par oxydation thermique, notamment à haute température (ou HTO, pour « High Température Oxide » en anglais). Cette couche peut être aussi obtenue par une étape de croissance de silicium et oxydation du silicium. Son épaisseur est par exemple comprise entre 5 nm et 200 nm. La couche de protection 13 peut être aussi formée par un empilement bicouche comprenant une sous-couche de SiO₂ (1-20 nm) disposée sur une sous-couche de SiN (10-80 nm).

Les première et deuxième régions 10A-10B de la structure multicouches 10, définies (ou délimitées) à l'étape S2, sont avantageusement destinées à recevoir des transistors à effet de champ de types opposés. Plus particulièrement, la première région 10A est destiné à la formation d'un transistor nFET, tandis que la deuxième région 10B est destinée à la formation d'un transistor pFET.

L'étape S4 de recuit laser comprend deux phases :
- une première phase dite de fusion, lors de laquelle la portion 110B de la structure multicouches 10 (comprenant une partie de la couche de SiGe 12) est fondue ; et
- une deuxième phase dite de recristallisation, lors de laquelle la portion fondue est recristallisée sous la forme d'une couche semi-conductrice 110B', 110B" dotée du gradient de concentration en germanium.

Lors de la première phase de fusion, les atomes de germanium de la couche de SiGe 12 sont dispersés dans la portion fondue (on parle de « redistribution du germanium »).

Le gradient de concentration en germanium est le résultat d'un mécanisme de ségrégation des atomes en germanium lors de la deuxième phase de recristallisation. La recristallisation s'effectuant du substrat 11 vers la couche de protection 13 (autrement dit de bas en haut sur les figures), des atomes de germanium sont concentrés à l'interface ou à proximité immédiate de l'interface entre la couche de protection 13 et la portion 110B de la structure multicouches 10 (au lieu d'être repoussés vers le substrat 11 lors d'une condensation de germanium par oxydation thermique).

La couche semi-conductrice 110B', 110B", correspondant à la portion modifiée par le recuit laser, est à base de SiGe. Elle comporte une première partie appauvrie en germanium et une deuxième partie enrichie en germanium disposée sur la partie appauvrie en germanium. Par « partie appauvrie en germanium », on désigne une portion dont la concentration en germanium est plus faible que la concentration en germanium initiale de la couche de SiGe 12. A l'inverse, on appelle « partie enrichie en germanium » une portion dont la concentration en germanium est plus forte que la concentration en germanium initiale de la couche de SiGe 12. La partie enrichie en germanium de la couche semi-conductrice 110B', 110B", en contact avec la couche de protection 13, forme la deuxième zone semi-conductrice 100B (optimisée pour la conduction par trous).

De préférence, la concentration en germanium initiale de la couche de SiGe 12 et l'épaisseur de la portion 110B (en particulier dans la couche de SiGe 12) sont choisies de façon à obtenir une concentration maximale en germanium à l'interface avec la couche de protection 13 comprise entre 20 % et 60 %. La portion 110B peut ainsi s'étendre de la couche de protection 13 jusqu'au substrat 11 (et donc comprendre la couche de SiGe 12 dans toute son épaisseur).

La couche semi-conductrice 110B', 110B" est sous contrainte en compression biaxiale dans le plan. Cette contrainte en compression, due à la différence des paramètres de maille entre le silicium et le silicium-germanium, est particulièrement forte dans la partie enrichie en germanium, autrement dit dans la portion supérieure de la couche semi-conductrice 110B', 110B" (en contact avec la couche de protection 13). La contrainte en compression augmente la mobilité des trous par rapport à une couche relaxée (c.-à-d. sans contraintes dans le plan) du même matériau.

Le recuit laser est accompli en exposant la surface de la structure multicouches 10 à un rayonnement émis par une source laser. Une partie au moins du rayonnement laser traverse la couche de protection 13 dans la deuxième région 10B de la structure multicouches 10. La couche de protection 13 n'est toutefois pas fondue sous l'effet du rayonnement laser.

Le rayonnement laser présente avantageusement une longueur d'onde comprise entre 200 nm et 600 nm et une densité d'énergie comprise entre 0,1 J/cm² et 10 J/cm². La durée d'exposition au rayonnement laser (pour chaque unité de surface de la couche de protection 13) peut être comprise entre 10 ns et 1000 ns, préférentiellement entre 20 ns et 300 ns.

La couche de protection 13, aussi appelée couche de couverture (« capping layer » en anglais), améliore l'état de surface de la couche semi-conductrice 110B', 110B". Plus particulièrement, la couche de protection 13 empêche la contamination de la surface de la couche semi-conductrice 110B', 110B" et diminue sa rugosité. Cet état de surface amélioré s'avère particulièrement bénéfique pour les performances du transistor pFET.

Une façon préférentielle de localiser le recuit laser dans la deuxième région 10B de la structure multicouches 10 consiste à utiliser une couche de réflexion laser 14. Cette couche de réflexion laser 14 est configurée pour diminuer l'efficacité du recuit laser, en réfléchissant une grande partie du rayonnement laser. La couche de réflexion laser 14 est formée uniquement dans la première région 10A de la structure multicouches, de sorte que le rayonnement laser atteignant cette région soit réfléchi et n'affecte pas les couches sous-jacentes de la structure multicouches 10.

Ainsi, dans les modes de mise en oeuvre des figures 1A-1D, 2A-2D, 3A-3D et 4A-4E, la structure multicouches 10 fournie à l'étape S1 comprend en outre la couche de réflexion laser 14 disposée sur la couche de protection 13 (ou sur la couche de SiGe 12 en l'absence de la couche de protection 13) et le procédé de fabrication comprend en outre, avant l'étape S4 de recuit laser, une étape S3 de retrait d'une portion de la couche de réflexion laser 14 située dans la deuxième région 10B de la structure multicouches 10 (cf. figure 1C, figure 2C, figure 3C et figure 4C).

La couche de réflexion laser 14 peut être formée par une couche de nitrure de silicium (ex. Si₃N₄) dont l'épaisseur est choisie pour obtenir un comportement réfléchissant à la longueur d'onde du rayonnement laser. L'épaisseur de la couche de nitrure de silicium est de préférence comprise entre 10 nm et 60 nm. Alternativement, la couche de réflexion laser 14 peut être formée par un empilement de plusieurs sous-couches, par exemple une première sous-couche en dioxyde de silicium (SiO₂) et une deuxième sous-couche en nitrure de silicium (Si₃N₄) disposée sur la première sous-couche.

Une couche de réflexion laser 14 peut être facilement limitée à une région de la structure multicouches (par exemple par gravure au travers d'un masque dur ou en résine) même si cette région présente une faible superficie.

Les figures 1A à 1D illustrent un premier mode de mise en oeuvre du procédé de fabrication.

En référence à la figure 1A, la structure multicouches 10 fournie à l'étape S1 comprend successivement le substrat 11, la couche de SiGe 12, la couche de protection 13 et la couche de réflexion laser 14. La couche de SiGe 12 présente une concentration en germanium comprise entre 5 % et 10 %, par exemple égale à 5 %. Son épaisseur peut être comprise entre 5 nm et 100 nm.

A l'étape S2 de la figure 1B, les première et deuxième régions 10A-10B de la structure multicouches 10 sont définies (ou délimitées) en gravant une tranchée 15 dans la structure multicouches 10. La tranchée 15 s'étend à travers la couche de réflexion laser 14, la couche de protection 13 et la couche de SiGe 12 jusqu'au substrat 11. La couche de réflexion laser 14, la couche de protection 13 et la couche de SiGe 12 comprennent ainsi chacune une première portion située dans la première région 10A et une deuxième portion située dans la deuxième région 10B. La tranchée 15 peut également s'étendre en partie dans le substrat 11 (une portion superficielle du substrat 11 est alors gravée). Puis, la tranchée 15 est remplie au moins partiellement d'un matériau électriquement isolant, afin de former une tranchée d'isolation électrique 16 (aussi appelée STI, pour « shallow trench isolation » en anglais). Le matériau électriquement isolant est déposée sur au moins toute l'épaisseur de la couche de SiGe 12. Ainsi, la tranchée d'isolation électrique 16 sépare et isole électriquement les deux portions de la couche de SiGe 12. Le matériau électriquement isolant est par exemple un oxyde de silicium (ex. SiO₂) ou un nitrure de silicium (ex. Si₃N₄).

La figure 1C représente l'étape S3 de retrait de la deuxième portion de la couche de réflexion laser 14, située dans la deuxième région 10B de la structure multicouches 10. Le retrait peut être accompli par gravure de la couche de réflexion laser 14 (par exemple en Si₃N₄) au travers d'un masque, la gravure étant avantageusement sélective par rapport à la couche de protection 13 (par exemple en SiO₂).

Enfin, en référence à la figure 1D, l'étape de recuit laser S4 est accomplie de manière à obtenir la couche semi-conductrice 110B' présentant le gradient de concentration en germanium. Comme indiqué précédemment, la partie enrichie en germanium obtenue dans la deuxième région 10B (en contact avec la couche de protection 13) forme la deuxième zone semi-conductrice 100B (optimisée pour la conduction par trous). La première zone semi-conductrice 100A (optimisée pour la conduction par électrons) est, dans ce premier mode de mise en oeuvre, formée par une portion non-modifiée (par le recuit laser) de la couche de SiGe 12.

Les figures 2A à 2D illustrent un deuxième mode de mise en oeuvre du procédé de fabrication.

Ce deuxième mode de mise en oeuvre diffère du premier mode de mise en oeuvre principalement dans la constitution de la structure multicouches 10 (aussi appelée empilement de départ).

En référence à la figure 2A, la structure multicouches 10 fournie à l'étape S1 comprend, outre le substrat 11, la couche de SiGe 12, la couche de protection 13 et la couche de réflexion laser 14, une couche de silicium 17 disposée entre la couche de SiGe 12 et la couche de protection 13. La couche de SiGe 12 présente ici une concentration en germanium supérieure ou égale à 10 %. Son épaisseur peut être comprise entre 5 nm et 100 nm. L'épaisseur de la couche de silicium 17 est de préférence comprise entre 5 nm et 30 nm.

Les première et deuxième régions 10A-10B de la structure multicouches 10 sont définies à l'étape S2 de la figure 2B sensiblement de la même façon que décrite en relation avec la figure 1B. La tranchée 15 s'étendant de la couche de réflexion laser 14 au substrat 11, elle traverse également la couche de silicium 17. Le matériau électriquement isolant déposé à l'intérieur pour former la tranchée d'isolation électrique 16 s'étend au moins sur toute l'épaisseur de la couche de SiGe 12 et de la couche de silicium 17.

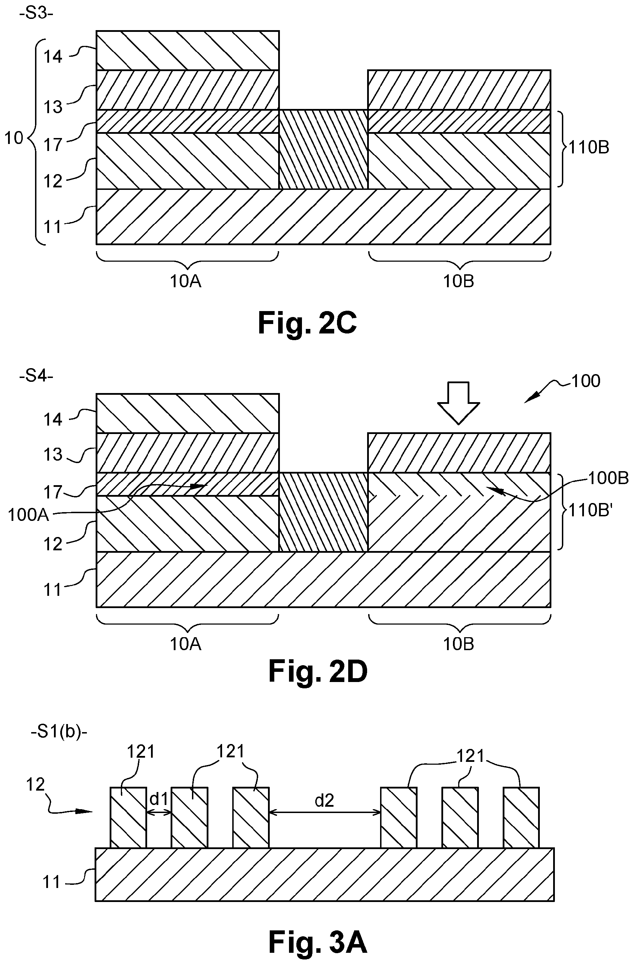

La portion 110B de la structure multicouches modifiée (fondue et recristallisée) lors de l'étape S4 de recuit laser comprend une partie de la couche de silicium 17, en plus d'une partie de la couche de SiGe 12 (cf. figure 2C avant recuit et figure 2D après recuit). Les portions fondues de la couche de silicium 17 et de la couche de SiGe 12 forment donc une seule phase liquide (un alliage de SiGe). Lors du refroidissement, les atomes de germanium se concentrent dans la phase liquide restante qui diminue peu à peu. La couche de silicium 17 initiale est ainsi transformée (localement) en alliage de silicium-germanium.

A nouveau, la couche semi-conductrice 110B' obtenue à l'issue du recuit laser dans la deuxième région 10B de la structure multicouches 10 comprend une partie appauvrie en germanium et une partie enrichie en germanium. La partie enrichie en germanium forme la deuxième zone semi-conductrice 100B. La première zone semi-conductrice 100A est, dans ce deuxième mode de mise en oeuvre, formée par la couche de silicium 17 (désormais limitée à la première région 10A).

Les figures 3A à 3D illustrent un troisième mode de mise en oeuvre du procédé de fabrication, adapté à la formation de transistors à effet de champ à ailettes (ou FinFET, pour « fin field-effect transistor» en anglais) dans les première et deuxième régions 10A-10B de la structure multicouches.

Dans ce troisième mode de mise en oeuvre, la couche de SiGe 12 de la structure multicouches 10 fournie à l'étape S1 est structurée sous la forme d'une pluralité d'ailettes 121 distinctes et la structure multicouches 10 comprend en outre des tranchées d'isolation électrique 16' séparant les ailettes 12 entre elles. En outre, comme dans le premier mode de mise en oeuvre (Figs.1A-1D), la couche de SiGe 12 présente (avant recuit laser) une concentration en germanium comprise entre 5 % et 10 %.

Les ailettes désignent des portions de couche de forme allongée ayant une longueur (mesurée perpendiculairement au plan de coupe des figures) bien supérieure à leur largeur (mesurée dans le plan de coupe des figures, parallèlement à la face du substrat 11 sur laquelle est disposée la couche de SiGe 12).

L'étape S1 de fourniture de la structure multicouches 10 comprend de préférence les sous-étapes suivantes :
a) le dépôt de la couche de SiGe 12 sur le substrat 11, par exemple par épitaxie ;
b) le gravure de la couche de SiGe 12 de manière à former la pluralité d'ailettes 121 ;
c) la formation des tranchées d'isolation électrique 16' entre les ailettes 121 ; et de préférence
d) le dépôt de la couche de protection 13 sur la couche de SiGe 12.

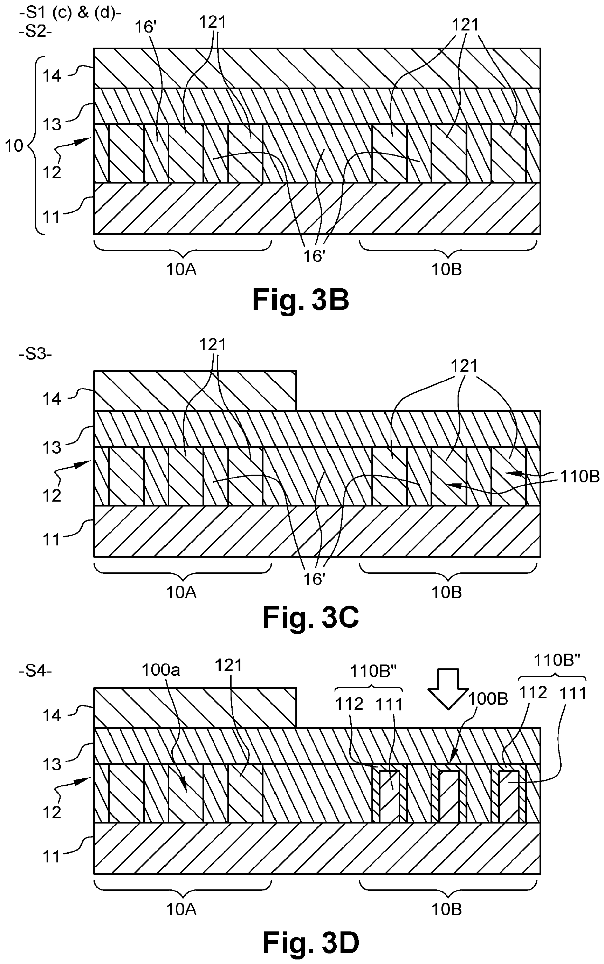

La sous-étape b) de gravure de la couche de SiGe 12 est illustrée par la figure 3A, tandis que la sous-étape c) de formation des tranchées d'isolation électrique 16' et la sous-étape d) de dépôt de la couche de protection 13 sont illustrées par la figure 3B.

La gravure de la couche SiGe 12 peut être réalisée au travers d'un masque en résine ou d'un masque dur (non représenté sur la figure 3A), formé préalablement sur la couche de SiGe 12.

La couche de SiGe 12 est ici gravée de manière à former deux groupes d'ailettes 121, l'un situé dans la première région 10A de la structure multicouches 10 et l'autre situé dans la deuxième région 10B de la structure multicouches 10. La distance d1 entre deux ailettes 121 consécutives dans chaque groupe est de préférence inférieure à la distance d2 séparant les deux groupes d'ailettes. Ainsi, plusieurs transistors FinFET pourront être formés dans chacune des première et deuxième régions 10A-10B.

Dans ce troisième mode de mise en oeuvre, il peut être considéré que les première et deuxième régions 10A-10B sont définies (ou délimitées) lors de la formation de la structure multicouches 10. Autrement dit, l'étape S2 de définition des première et deuxième régions 10A-10B est accomplie lors de l'étape S1 de formation de la structure multicouches 10. La tranchée d'isolation électrique 16' disposée entre les deux groupes d'ailettes correspond à la tranchée d'isolation électrique 16 des figures 1B et 2B.

Afin de simplifier la formation de la structure multicouches 10, la couche de protection 13 et les tranchées d'isolation électrique 16' peuvent être formées d'un même matériau électriquement isolant, par exemple du SiO₂. Le matériau électriquement isolant est avantageusement déposé de manière à remplir entièrement les tranchées entre les ailettes 121 et à former une couche de surépaisseur (i.e. la couche de protection 13) sur ces mêmes ailettes 121. La sous-étape d) de dépôt de la couche de protection 13 est alors immédiatement consécutive à la sous-étape c) de formation des tranchées d'isolation électrique 16' et peut être accomplie dans le même équipement de dépôt.

Enfin, l'étape S1 de fourniture de la structure multicouches 10 comprend avantageusement une sous-étape de dépôt de la couche de réflexion laser 14 sur la couche de protection 13 (cf. Fig.3B) ou sur les ailettes 121.

Après retrait de la portion de la couche de réflexion laser 14 située dans la deuxième région 10B (cf. figure 3C ; étape S3), la structure multicouches est soumise à l'étape S4 de recuit laser (cf. Fig.3D) afin d'obtenir dans la deuxième région 10B plusieurs portions de couche semi-conductrice 110B" (en forme d'ailettes) présentant chacune un gradient de concentration en germanium. Chaque portion de couche semi-conductrice 110B" résulte de la modification d'une partie au moins d'une ailette 121.

Dans le cas d'ailettes, c'est-à-dire de portions de très faible largeur (typiquement comprise entre 5 nm et 50 nm), la redistribution des atomes de germanium s'effectue non seulement du substrat 11 vers la couche de protection 13 mais également de l'intérieur vers l'extérieur des ailettes 121. Les atomes de germanium sont ainsi concentrés à l'interface avec la couche de protection 13 mais aussi à l'interface avec les tranchées d'isolation électrique 16'. Chaque portion de couche semi-conductrice 110B" comprend alors une partie appauvrie en germanium 111 disposée au centre (telle un noyau) et une partie enrichie en germanium 112 qui enveloppe la partie appauvrie 111 en germanium (telle une coquille).

Chaque partie enrichie en germanium 112 dans la deuxième région 10B forme une deuxième zone semi-conductrice 100B optimisée pour la conduction par trous et chaque ailette 121 non modifiée (en SiGe de faible concentration) dans la première région 10A forme une première zone semi-conductrice 100A optimisée pour la conduction par électrons.

De préférence, les conditions du recuit laser sont telles que les ailettes 121 sont entièrement fondues puis recristallisées (dans la deuxième région 10B). Ainsi, les parties enrichies en germanium 112 s'étendent jusqu'au substrat 11, autrement dit sur toute la hauteur des ailettes. Cette configuration est particulièrement bénéfique pour les performances des transistors pFET, étant donné que la grille de ces transistors recouvre généralement les trois côtés de l'ailette (la face supérieure et les deux faces latérales dans le plan de coupe de la figure 3D).

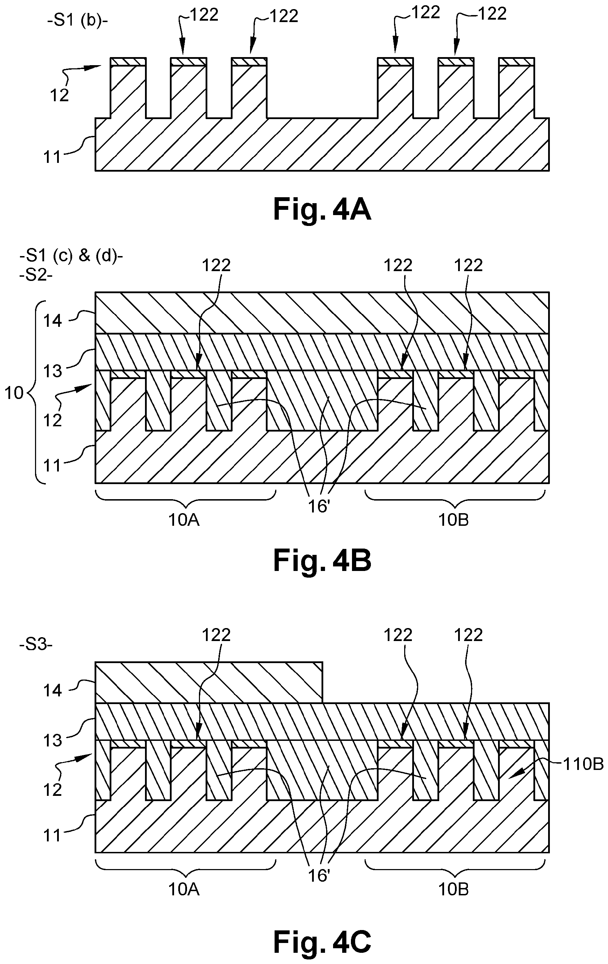

Les figures 4A à 4E illustrent un quatrième mode de mise en oeuvre du procédé de fabrication. Ce quatrième mode de mise en oeuvre ressemble au troisième mode de mise oeuvre dans la mesure où la structure multicouches 10 comprend également des ailettes 122 réparties entre les première et deuxième régions 10A-10B et des tranchées d'isolation électrique 16' entre les ailettes 122. Il est donc également adapté à la formation de transistors FinFET.

A l'instar des figures 3A-3B, la figure 4A et la figure 4B représentent des sous-étapes de l'étape S1 de fourniture de la structure multicouches 10.

Après le dépôt de la couche de SiGe 12 sur le substrat 11 (sous-étape a)), la couche de SiGe 12 et une portion du substrat 11 sont gravées de manière à former la pluralité d'ailettes 122 (cf. Fig.4A ; sous-étape b)). De préférence, la portion du substrat 11 qui est gravée en même temps que la couche de SiGe 12 est en silicium. Il peut notamment s'agir de la couche mince en silicium (aussi appelée couche active) d'un substrat SOI, typiquement une couche de silicium monocristallin. L'épaisseur de la couche mince en silicium est généralement comprise entre 5 nm et 80 nm.

Puis, en référence à la figure 4B, les tranchées d'isolation électrique 16' et la couche de protection 13 sont formées de la façon décrite en relation avec la figure 3B (sous-étapes c) et d)) et, de préférence, en utilisant le même matériau électriquement isolant.

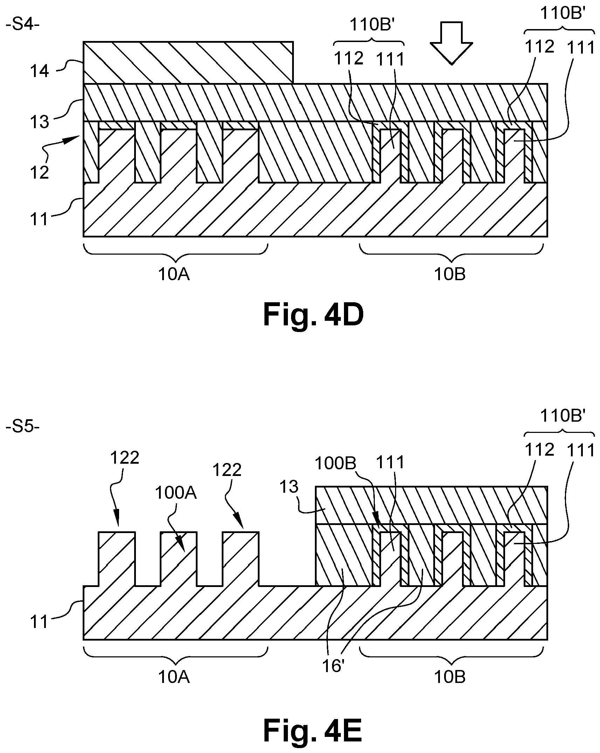

Lors de l'étape S4 de recuit laser (cf. figure 4D), les atomes de germanium contenus dans la couche de SiGe 12 de chaque ailette 122 sont dispersés puis concentrés aux interfaces avec la couche de protection 13 et les tranchées d'isolation électrique 16', comme décrit précédemment en relation avec la figure 3D. Il en résulte les différentes portions de couche semi-conductrice 110B" en forme d'ailettes. Dans le cas d'un substrat SOI, le recuit laser est avantageusement accompli de sorte à ne pas fondre la couche de silicium monocristallin du substrat SOI sur toute son épaisseur, autrement dit jusqu'à la couche d'oxyde enterrée (BOX). Cela permet aux portions de couche semi-conductrice 110B" en forme d'ailettes de se recristalliser sous une forme monocristalline.

Dans ce quatrième mode de mise en oeuvre, la couche de SiGe 12 présente avantageusement (avant recuit laser) une concentration en germanium supérieure ou égale à 30 %. Une telle concentration est importante pour que suffisamment d'atomes de germanium puissent être dispersés lors de la phase de fusion, puis redistribués lors de la phase de recristallisation. L'épaisseur de la couche de SiGe 12 peut alors être plus faible que dans les autres modes de mise en oeuvre, par exemple comprise entre 5 nm et 10 nm (au lieu de 5 nm - 100 nm).

Enfin, lors d'une étape S5 illustrée par la figure 4E, la couche de protection 13 est retirée dans la première région 10A de la structure multicouches 10 (de même que la couche de réflexion laser 14, si nécessaire), puis la couche de SiGe 12 y est gravée sélectivement par rapport au substrat 11. Les tranchées d'isolation électrique 16' situées dans la première région 10A peuvent être également gravées (notamment lorsqu'elles sont formées du même matériau que la couche de protection 13).

On obtient alors, à l'issue de cette étape S5, des ailettes en silicium 122 dans la première région 10A de la structure multicouches 10 et des ailettes à base de SiGe 110B" dans la deuxième région 10B (recouvertes de la couche de protection 13). Chaque ailette 122 dans la première région 10A forme une première zone semi-conductrice 100A et la partie enrichie en germanium 112 de chaque ailette à base de SiGe 110B" (ou portion de couche semi-conductrice) forme une deuxième zone semi-conductrice 100B.

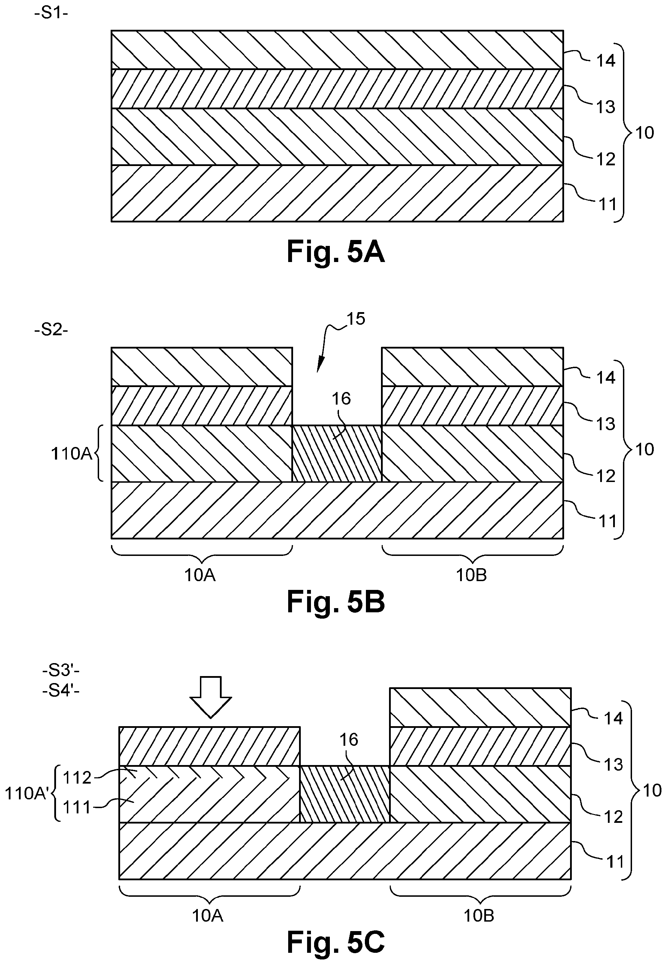

Les figures 5A-5D, 6A-6D et 7A-7C représentent trois autres modes de mise en oeuvre du procédé de fabrication.

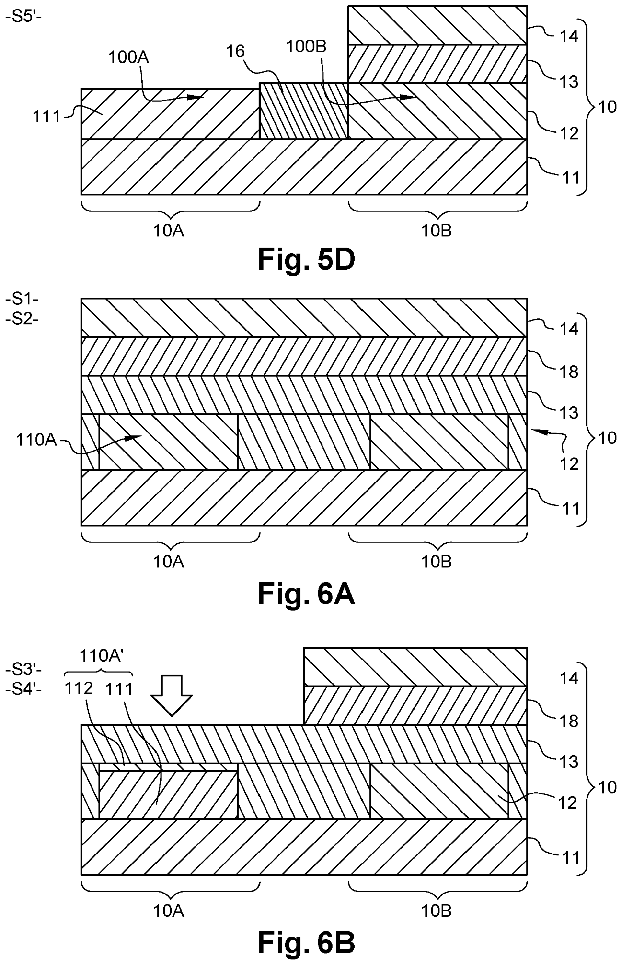

D'une manière commune à ces trois autres modes de mise en oeuvre, le procédé de fabrication comprend les étapes S1, S2, S4' et S5' suivantes :
- S1 : fournir une structure multicouches 10 comprenant un substrat 11 et une couche de SiGe 12 disposée sur le substrat 11 (cf. Figs.5A, 6A et 7A) ;
- S2 : définir dans la structure multicouches 10 une première région 10A destinée à contenir la première zone semi-conductrice 100A et une deuxième région 10B destinée à contenir la deuxième zone semi-conductrice 100B (cf. Figs.5B, 6A et 7A) ; et
- S4' : soumettre la structure multicouches 10 à un recuit laser de manière à modifier une ou plusieurs portions 110A de la structure multicouches 10 situées dans la première région 10A, chaque portion 110A comprenant avant le recuit laser une partie de la couche de SiGe 12, chaque portion étant modifiée de sorte qu'elle comprenne après le recuit laser une partie appauvrie en germanium 111 et une partie enrichie en germanium 112 disposée sur la première partie 111 (cf. Figs.5C, 6B et 7B) ; et
- S5' : graver la partie enrichie en germanium 112 de manière à exposer la partie appauvrie en germanium 111 (cf. Figs.5D, 6C et 7C).

Comme précédemment, la structure multicouches 10 comprend avantageusement une couche de protection 13 disposée sur la couche de SiGe 12. Chaque portion 110A s'étend alors jusqu'à la couche de protection 13. La couche de protection 13 est retirée dans la première région 10A de la structure multicouches 10 avant de graver la partie enrichie en germanium 112 (étape S5').

L'étape S1 de fourniture de la structure multicouches et l'étape S2 de définition des première et deuxième régions 10A-10B ont été décrites précédemment.

L'étape S4' de recuit laser diffère de l'étape S4 décrite précédemment en ce que la (ou les) portion(s) de la structure multicouches 10 modifiée par le recuit laser se situe dans la première région 10A au lieu de la deuxième région 10B. Après retrait de la partie enrichie en germanium 112, la partie appauvrie en germanium 111 forme la première zone semi-conductrice 100A (optimisée pour la conduction par électrons).

Ainsi, l'objectif final du procédé selon ces trois modes de mise en oeuvre n'est pas de concentrer les atomes de germanium dans la deuxième région 10B pour former la deuxième zone semi-conductrice 100B (optimisée pour la conduction par trous), mais au contraire d'appauvrir (ou dépléter) en germanium la couche de SiGe 12 dans la première région 10A pour former la première zone semi-conductrice 100A.

A nouveau, une couche de réflexion laser 14 peut être utilisée pour localiser le recuit laser. Toutefois, la couche de réflexion laser 14 est ici formée uniquement dans la deuxième région 10B de la structure multicouches.

Ainsi, dans les modes de mise en oeuvre des figures 5A-5D et 6A-6D, la structure multicouches 10 fournie à l'étape S1 comprend en outre la couche de réflexion laser 14 disposée sur la couche de protection 13 (ou sur la couche de SiGe 12) et le procédé de fabrication comprend en outre, avant l'étape S4' de recuit laser, une étape S3' de retrait d'une portion de la couche de réflexion laser 14 située dans la première région 10A de la structure multicouches 10 (cf. Figs.5C et 6B)

Les figures 5A à 5D illustrent un cinquième mode de mise en oeuvre du procédé de fabrication.

L'étape S1 de fourniture de la structure multicouches 10 et l'étape S2 de définition des première et deuxième régions 10A-10B (cf. figure 5A et figure 5B) sont sensiblement identiques à celles décrites en relation avec les figures 1A-1B (premier mode de mise en oeuvre). La seule différence est que la couche de SiGe 12 présente ici une concentration en germanium supérieure ou égale à 30 %.

Après retrait de la portion de la couche de réflexion laser 14 située dans la première région 10A (étape S3'), la structure multicouches 10 est soumise à l'étape S4' de recuit laser afin d'obtenir dans la première région 10A la couche semi-conductrice 110A' (à base de SiGe) comprenant la partie appauvrie en germanium 111 et la partie enrichie en germanium 112 (cf. Fig.5C).

Puis, à l'étape S5' représentée par la figure 5D, la couche de protection 13 est retirée dans la première région 10, par gravure sélective par rapport à la couche semi-conductrice 110A', puis la partie enrichie en germanium 112 de la couche semi-conductrice 110A' est gravée entièrement, de manière à exposer la partie appauvrie en germanium 111. La partie appauvrie en germanium 111 peut être également gravée en partie (supérieure), en fonction de la concentration en germanium souhaitée dans la première région 10A. En effet, plus on se rapproche du substrat 11, plus la concentration en germanium de la couche semi-conductrice 110A' diminue.

La partie enrichie en germanium de la couche semi-conductrice 110B' peut être gravée au moyen d'une solution de gravure, par exemple un mélange d'acide acétique, d'acide fluorhydrique et de peroxyde d'hydrogène.

La partie appauvrie en germanium 111 forme la première zone semi-conductrice 100A, tandis que la portion non-modifiée de la couche de SiGe 12 forme la deuxième zone semi-conductrice 100B.

Les figures 6A à 6C illustrent un sixième mode de mise en oeuvre du procédé de fabrication.

Ce sixième mode de mise en oeuvre diffère du cinquième mode de mise en oeuvre essentiellement dans la manière dont sont définies les première et deuxième régions 10A-10B de la structure multicouches 10 (étape S2).

La couche de SiGe 12 est ici gravée après son dépôt sur le substrat 11 et avant le dépôt de la couche de protection 13, alors que dans le cinquième mode de mise en oeuvre, elle est gravée après avoir complètement formé la structure multicouches 10 (tranchée 15). Autrement dit, les étapes S1 et S2 sont accomplies comme dans le troisième mode de mise en oeuvre (cf. Figs.3A-3B), sauf que la couche de SiGe 12 n'est pas structurée sous forme d'ailettes.

Ainsi, l'étape S1 de fourniture de la structure multicouches (figure 6A) comprend les sous-étapes suivantes :
a) le dépôt de la couche de SiGe 12 sur le substrat 11, par exemple par épitaxie ;
b) le gravure de la couche de SiGe 12 de manière à obtenir une première portion située dans la première région 10A et une deuxième portion située dans la deuxième région 10B ;
c) la formation d'une tranchée d'isolation électrique 16' entre les première et deuxième portions de la couche de SiGe 12 ; et de préférence
d) le dépôt de la couche de protection 13 sur la couche de SiGe 12.

La couche de protection 13 peut être formée sur la couche de SiGe 12 en déposant le même matériau électriquement isolant que celui formant la tranchée d'isolation électrique 16', comme décrit en relation avec la figure 3B.

L'étape S1 de fourniture de la structure multicouches 10 comprend avantageusement une sous-étape de dépôt de la couche de réflexion laser 14 sur la couche de protection 13 (ou sur les première et deuxième portions de la couche de SiGe 12).

Entre la sous-étape d) de dépôt de la couche de protection 13 et la sous-étape de dépôt de la couche de réflexion laser 14, l'étape S1 de fourniture de la structure multicouches 10 peut également comprendre une sous-étape de formation d'une couche de masque dur 18 sur la couche de protection 13. La couche de masque dur 18 est par exemple en SiN ou SiO₂. Cette couche de masque dur 18 peut également faire partie la couche de réflexion laser 14 (SiO₂ + SiN).

La couche de masque dur 18 est gravée dans la première région 10A de la structure multicouches 10 après la gravure de la couche de réflexion laser 14 (étape S3') et, de préférence, avant l'étape de recuit laser S4', comme cela est représenté par la figure 6B.

Comme décrit précédemment en relation avec la figure 5C, le recuit laser permet d'obtenir dans la première région 10A de la structure multicouches 10 une couche semi-conductrice 110A' comprenant une partie appauvrie en germanium 111 et une partie enrichie en germanium 112 (cf. Fig.6B).

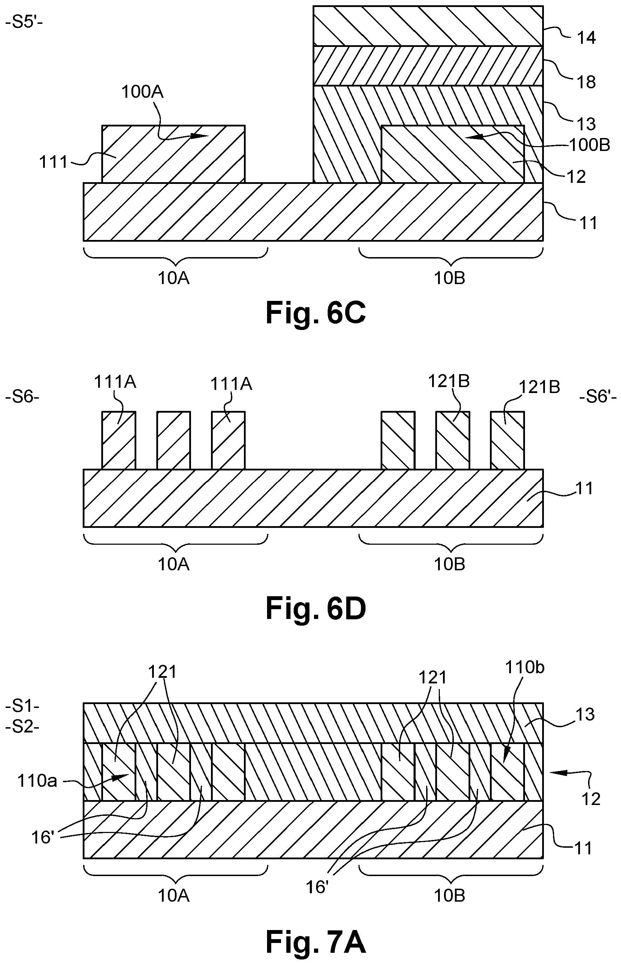

La figure 6C illustre l'étape S5' comprenant le gravure de la couche de protection 13 dans la première région 10A et la gravure de la partie enrichie en germanium 112. Ces deux opérations de gravure peuvent être accomplie en se servant de la couche de réflexion laser 14 ou de la couche de masque dur 18 (lorsque la couche de réflexion laser 14 a été préalablement retirée) comme d'un masque de gravure.

Après l'étape S5' de gravure de la partie enrichie en germanium 112 illustrée par la figure 5D ou la figure 6C, le procédé de fabrication peut comprendre les étapes suivantes :
- S6 : graver la partie appauvrie en germanium 111 de manière à former une pluralité de premières ailettes 111A dans la première région 10A de la structure multicouches 10 ;
- S6' : retirer la couche de réflexion laser 14 et la couche de protection 13 située dans la deuxième région 10B, puis graver la portion non-modifiée de la couche de SiGe 12 de manière à former une pluralité de deuxièmes ailettes 121B dans la deuxième région 10B de la structure multicouches 10.

Ainsi, des régions de canal de transistors FinFET (NMOS et PMOS) sont formées dans chacune des première et deuxième régions 10A-10B.

La gravure (ou structuration) de la partie appauvrie en germanium 111 (étape S6) peut être accomplie immédiatement après l'étape S5' de gravure de la partie enrichie en germanium 112. Les premières ailettes 111A sont ensuite recouvertes d'un masque, puis la couche de réflexion laser 14, la couche de masque dur 18 (le cas échéant) et la couche de protection 13 sont retirées successivement (par gravure à travers le masque), pour donner accès la couche de SiGe 12. Enfin, la couche de SiGe 12 est structurée pour former les deuxièmes ailettes 121B (étape S6').

Les étapes de gravure pour former les premières ailettes 111A dans la première région 10A et les deuxièmes ailettes 121B dans la deuxième région 10B peuvent être également accomplies simultanément (après retrait de la couche de réflexion laser 14, de la couche de masque dur 18 et de la couche de protection 13.

Les figures 7A à 7C illustrent un septième mode de mise en oeuvre du procédé de fabrication, adapté à la formation de transistors FinFET.

L'étape S1 de fourniture de la structure multicouches 10 et l'étape S2 de définition des première et deuxième régions 10A-10B représentées par la figure 7A sont accomplies d'une façon sensiblement identique à celle décrite en relation avec les figures 3A-3B (troisième mode de mise en oeuvre). La couche de SiGe 12 est notamment structurée en une pluralité d'ailettes 121 réparties entre les première et deuxième régions 10A-10B et séparées entre elles par des tranchées d'isolation électrique 16'. Une différence est que la couche de SiGe 12 présente ici une concentration en germanium supérieure ou égale à 15 %.

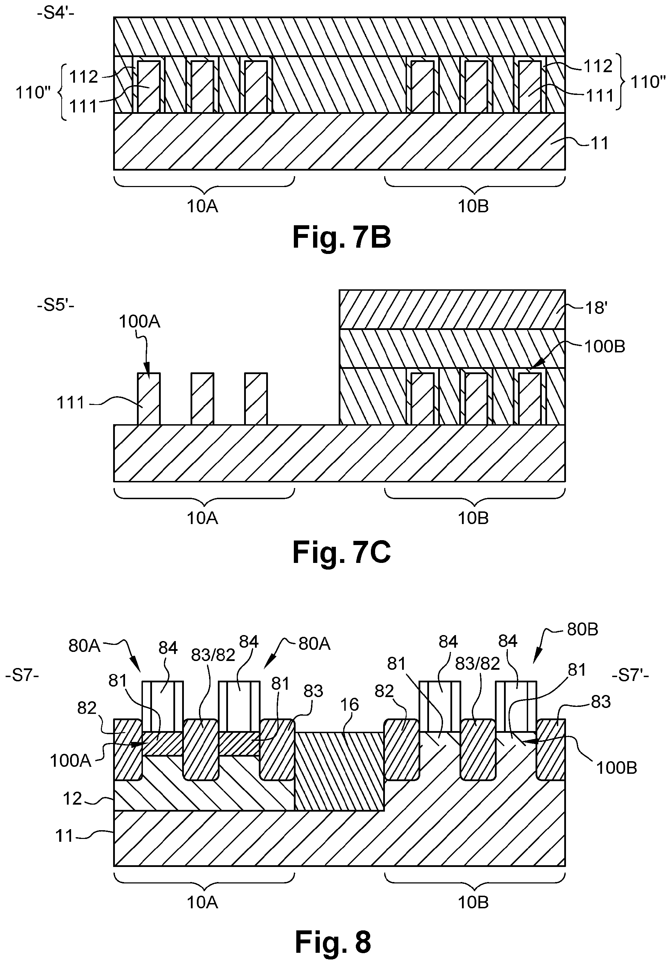

Ensuite, à l'étape S4' (cf. figure 7B), la structure multicouches 10 est soumise au recuit laser de manière à modifier des portions 110A de la structure multicouches 10 situées dans la première région 10A et des portions 110B de la structure multicouches 10 situées dans la deuxième région 10B, chaque portion 110A, 110B comprenant une partie au moins d'une ailette 121 et s'étendant jusqu'à la couche de protection 13.

Pour ce faire, la structure multicouches 10 est dépourvue de couche de réflexion laser 14. Le procédé de fabrication ne comprend donc pas de sous-étape de dépôt de la couche de réflexion laser 14 sur la couche de protection 13, ni d'étape de retrait S3' d'une portion de la couche de réflexion laser 14 située dans la première région 10A. En revanche, la structure multicouches 10 peut comprendre une couche de masque dur (non représentée) disposée sur la couche de protection 13.

Le recuit laser affecte ainsi toutes les ailettes 121 de la couche de SiGe 12. Chaque ailette 121 est transformée (au moins en partie) en une portion de couche semi-conductrice 110" comprenant une partie appauvrie en germanium 111 et une partie enrichie en germanium 112 qui enveloppe la partie appauvrie en germanium 111.

A l'étape S5' de la figure 7C, la couche de protection 13 et la partie enrichie en germanium 112 des portions de couche semiconductrice 110" sont gravées successivement dans la première région 10A. Ces deux opérations de gravure sont accomplies après avoir formé un masque dur 18' dans la deuxième région 10B, sur la couche de protection 13. Le masque dur 18' est obtenu en gravant une portion d'une couche de masque dur déposée sur la couche de protection 13 avant le recuit laser, par exemple lors de la formation de la structure multicouches (étape S1), ou après le recuit laser (étape S4).

Chaque partie appauvrie en germanium 111 située dans la première région 10A forme une première zone semi-conductrice 100A optimisée pour la conduction par électrons et chaque partie enrichie en germanium 112 située dans la deuxième région 10B forme une deuxième zone semi-conductrice 100A optimisée pour la conduction par trous.

Dans une variante de mise en oeuvre du procédé selon les figures 7A-7C, adaptée à la formation de transistors planaires (ex. MOSFET à grille simple), la couche de SiGe 12 de la structure multicouches 10 est laissée intact (c-à-d. elle n'est pas structurée) avant l'étape S4' de recuit laser. Puis, une partie au moins de la couche de SiGe 12 s'étendant dans la première région 10A et dans la deuxième région 10B est soumise au rayonnement laser. La couche de protection 13 et la partie enrichie en germanium 112 obtenue à l'issue du recuit laser sont gravées uniquement dans la première région 10A.

Les conditions du recuit laser (étape S4 ou S4') peuvent varier entre les différents modes de mise en oeuvre, en fonction de la composition initiale de la structure multicouches 10. Elles peuvent être déterminées au préalable au moyens de simulations, d'expériences ou de mesures.

La figure 8 représente de manière schématique des étapes optionnelles S7 et S7' du procédé de fabrication, compatibles avec l'un quelconque des modes de mise en oeuvre décrits précédemment.

Ces étapes S7 et S7', accomplies après l'étape S4 de recuit laser, l'étape S5 de retrait de la couche de SiGe 12 ou l'étape S5' de retrait de la partie enrichie en germanium 112 (selon le mode de mise en oeuvre) comprennent respectivement la formation d'un ou plusieurs transistors nFET 80A dans la première région 10A de la structure multicouches 10 et la formation d'un ou plusieurs transistors pFET 80B dans la deuxième région 10B de la structure multicouches 10. La manière dont sont accomplies ces étapes dépend notamment du type de transistors à effet de champ souhaité : transistor MOSFET à grille simple, transistor MOSFET à grille multiple (par exemple FinFET)...

Chaque transistor 80A, 80B comprend une région de canal 81 disposée sur le substrat 11, une région de drain 82 et une région de source 83 disposées sur le substrat 11 de part et d'autre de la région de canal 81 et une structure de grille 84 disposée sur la région de canal 81. La région de canal 81 des transistors nFET est formée dans une première zone semi-conductrice 100A optimisée pour la conduction par électrons, tandis que la région de canal 81 des transistors pFET est formée dans une deuxième zone semi-conductrice 100B optimisée pour la conduction par trous.

Dans le cas de transistors MOSFET à grille simple, les régions de canal 81 des transistors d'un même type (nFET ou pFET) peuvent être toutes formées dans la même zone semi-conductrice (première zone semi-conductrice 100A ou deuxième zone semi-conductrice 100B). Dans le cas de transistors FinFET, chaque ailette (111A, 121, 121B, 122) ou portion de couche semi-conductrice (110", 110B") en forme d'ailette comprend la région de canal d'un unique transistor.

L'ordre dans lequel sont accomplies les étapes S7 et S7' varie avantageusement selon le mode de mise en oeuvre du procédé de fabrication.

Par exemple, dans les trois premiers modes de mise en oeuvre (Figs.1D, 2D et 3D), il est avantageux de commencer par la formation des transistors pFET dans la deuxième région 10B, alors que la première zone semi-conductrice 100A est encore recouverte par la couche de protection 13 et la couche de réflexion laser 14. La couche de réflexion laser 14 dans la première région 10A peut servir de masque de gravure pour retirer la couche de protection 13 (et les tranchées d'isolation électrique 16', le cas échéant) dans la deuxième région 10B. Les transistors nFET peuvent alors être formés après avoir recouvert d'un masque les transistors pFET et après avoir retiré la couche de réflexion laser 14 et la couche de protection 13 dans la première région 10A.

Dans les quatre autres modes de mise en oeuvre suivants (Figs.4E, 5D, 6C et 7C), il est avantageux de commencer par la formation des transistors nFET dans la première région 10A, alors que la deuxième zone semi-conductrice 100B est encore recouverte par la couche de protection 13 (la couche de masque dur 18 et/ou la couche de réflexion laser 14, le cas échéant). Les transistors pFET peuvent alors être formés après avoir recouvert d'un masque les transistors nFET et après avoir retiré la couche de protection 13 (la couche de masque dur 18 et/ou la couche de réflexion laser 14, si nécessaire) dans la deuxième région 10B.

La formation des transistors FinFET dans les cinquième et sixième modes de mise en oeuvre commencera alors par la structuration de la première zone semi-conductrice 100A (en SiGe appauvri) pour former les ailettes (étape S6 ; figure 6D).

Les étapes S7 et S7' de formation des transistors nFET et pFET peuvent aussi être accomplies simultanément.

Comme indiqué précédemment, la différence des paramètres de maille entre le silicium et le silicium-germanium a pour effet de générer une contrainte en compression dans chaque deuxième zone semi-conductrice 100B. Les régions de canal 81 des transistors pFET 80B sont donc contraintes en compression. Etant donné que chaque deuxième région semi-conductrice 100B présente en outre une forte concentration en germanium, les transistors pFET 80B peuvent présenter des performances comparables à celles des transistors nFET 80A formés dans la première région 10A.

Dans le mode de mise en oeuvre des figures 2A-2D, une technique peut être mise en oeuvre pour contraindre en tension la région de canal 81 des transistors nFET, ce qui améliore la mobilité des électrons et augmente les performances des transistors nFET. Par exemple, les régions de drain et de source 82-83 peuvent être formées en gravant des cavités dans la première zone semi-conductrice 100A, de part et d'autre de la structure de grille 83, plus en réalisant une épitaxie de silicium dopé de manière à remplir les cavités.

Dans le cas de transistors FinFET, le recuit laser est avantageusement accompli de sorte à ne pas altérer (c.-à-d. fondre) le substrat 11. En effet, celui-ci peut contenir des dopants afin de former un plan de masse ou grille arrière dans les transistors FinFET.

## Revendications

1. Procédé de fabrication d'un dispositif semi-conducteur comprenant une première zone semi-conductrice (100A) optimisée pour la conduction par électrons et une deuxième zone semi-conductrice (100B) optimisée pour la conduction par trous, le procédé comprenant les étapes suivantes :
- fournir (S1) une structure multicouches (10) comprenant :
∘ un substrat (11) ; et
∘ une couche de silicium-germanium (12) disposée sur le substrat (11) ;
- définir (S2) dans la structure multicouches (10) une première région (10A) destinée à contenir la première zone semi-conductrice (100A) et une deuxième région (10B) destinée à contenir la deuxième zone semi-conductrice (100B) ;
- soumettre (S4') la structure multicouches (10) à un recuit laser de manière à modifier une portion (110A) de la structure multicouches située dans la première région (10A), ladite portion (110A) comprenant avant le recuit laser une partie de la couche de silicium-germanium (12), ladite portion comprenant après le recuit laser une partie appauvrie en germanium (111) et une partie enrichie en germanium (112) disposée sur la partie appauvrie en germanium (111) ;
- graver (S5') la partie enrichie en germanium (112) de manière à exposer la partie appauvrie en germanium (111).

2. Procédé selon la revendication 1, dans lequel la couche de silicium-germanium (12) présente avant le recuit laser une concentration en germanium supérieure ou égale à 30 %.

3. Procédé selon l'une des revendications 1 et 2, dans lequel la structure multicouches (10) comprend en outre une couche de protection (13) disposée sur la couche de silicium-germanium (12) et dans lequel ladite portion s'étend avant le recuit laser jusqu'à la couche de protection (13), le procédé comprenant en outre une étape (S5') de retrait de la couche de protection (13) dans la première région (10A) de la structure multicouches (10) avant l'étape de gravure de la partie enrichie en germanium (112).

4. Procédé selon la revendication 3, dans lequel la structure multicouches (10) comprend en outre une couche de réflexion laser (14) disposée sur la couche de protection (13), le procédé comprenant en outre, avant le recuit laser, une étape (S3') de gravure d'une portion de la couche de réflexion laser (14) située dans la première région (10A) de la structure multicouches (10).

5. Procédé selon la revendication 4, comprenant en outre, après l'étape (S5') de gravure de la partie enrichie en germanium (112), les étapes suivantes :
- structurer (S6) la partie appauvrie en germanium (111) de manière à former une pluralité de premières ailettes (111A) dans la première région (10A) de la structure multicouches (10) ;
- retirer (S6') la couche de réflexion laser (14) et la couche de protection (13) située dans la deuxième région (10B) de la structure multicouches (10) ;
- structurer (S6') la couche de silicium-germanium (12) de manière à former une pluralité de deuxièmes ailettes (121B) dans la deuxième région (10B) de la structure multicouches (10).

6. Procédé selon l'une des revendications 4 et 5, dans lequel l'étape (S2) de définition des première et deuxième régions (10A-10B) de la structure multicouches (10) est accomplie après l'étape (S1) de fourniture de la structure multicouches et comprend les sous-étapes suivantes :
- graver une tranchée (15) dans la structure multicouches (10), la tranchée (15) s'étendant à travers la couche de réflexion laser (14), la couche de protection (13) et la couche de silicium-germanium (12) jusqu'au substrat (11) ; et
- remplir la tranchée (15) d'un matériau électriquement isolant sur au moins toute l'épaisseur de la couche de silicium-germanium (12).

7. Procédé selon l'une quelconque des revendications 1 à 3, dans lequel :
- la couche de silicium-germanium (12) comprend une pluralité d'ailettes (121) réparties entre les première et deuxième régions (10A-10B) de la structure multicouches (10) ;
- la structure multicouches (10) comprend en outre des tranchées d'isolation électrique (16') séparant les ailettes (121) entre elles ; et
- la structure multicouches (10) est soumise au recuit laser de manière à modifier plusieurs portions de la structure multicouches situées dans la première région (10A) et plusieurs portions de la structure multicouches situées dans la deuxième région (10B), chaque portion comprenant avant le recuit laser une partie au moins d'une ailette (121).

8. Procédé selon la revendication 7 en dépendance de la revendication 3, dans lequel l'étape (S1) de fourniture de la structure multicouches (10) comprend les opérations suivantes :
a. déposer la couche de silicium-germanium (12) sur le substrat (11) ;
b. graver la couche de silicium-germanium (12) de manière à former la pluralité d'ailettes (121) ;
c. former les tranchées d'isolation électrique (16') entre les ailettes (121) ; et
d. déposer la couche de protection (13) sur la couche de silicium-germanium (12).

9. Procédé selon la revendication 8, dans lequel la couche de protection (13) et les tranchées d'isolation électrique (16') sont formées d'un même matériau électriquement isolant.

10. Procédé selon l'une quelconque des revendications 1 à 9, dans lequel le recuit laser est accompli en exposant la structure multicouches (10) à un rayonnement laser présentant une longueur d'onde comprise entre 200 nm et 600 nm et une densité d'énergie comprise entre 0,1 J/cm² et 10 J/cm² pendant une durée comprise entre 10 ns et 1000 ns.

11. Procédé selon l'une quelconque des revendications 1 à 10, comprenant en outre une étape (S7) de formation d'un transistor à effet de champ à canal N (80A), dit transistor nFET, dans la première région (10A) de la structure multicouches (10) et une étape (S7') de formation d'un transistor à effet de champ à canal P (80A), dit transistor pFET, dans la deuxième région (10B) de la structure multicouches (10).
